# EUROPEAN PATENT SPECIFICATION

(11) **EP 0 432 211 B1**
(45) Date of publication and mention of the grant of the patent: **02.06.1993**
(21) Application number: 89910125.7
(22) Date of filing: 31.08.1989
(51) Int. Cl.: G03G 13/28, G03F 7/30

(54) **PROCESS AND APPARATUS FOR PRODUCING PRINTING PLATES**
VERFAHREN UND APPARATUR ZUR HERSTELLUNG VON DRUCKPLATTEN
PROCEDE ET APPAREIL DE PRODUCTION DE PLANCHE D'IMPRESSION

(30) Priority: 02.09.1988 GB 8820781
(43) Date of publication of application: 19.06.1991
(73) Proprietor: Polychrome Corporation, Yonkers New York 10702 (US)
(72) Inventor: BROWN, Stephen, Denis, Hertfordshire (GB); GRANT, Euan, MacDonald, Hertfordshire WD1 7NT (GB); PATEL, Jayanti, Fairlawn, NJ 07412 (US)
(74) Representative: Jones, Helen Marjorie Meredith
(86) International application number: GB8901008
(87) International publication number: WO9002975

(56) References cited:
- EP-A- 0 080 659
- EP-A- 0 223 154
- GB-A- 2 020 228
- US-A- 3 995 343
- PATENT ABSTRACTS OF JAPAN, vo. 11, no. 68, (P-553)(2515), 28 February 1987, & JP-A-61230149 (KONISHIROKU), 14 October 1986.

## Description

The present invention relates to a new process for producing printing plates and apparatus for carrying out the process. Specifically the process is for decoating organic photo-conductor (OPC) plates to which a toner has been image-wise applied and cured.

Litho plates comprise a metal substrate, usually formed of aluminium although sometimes formed of zinc or other metals. A plate manufacturer provides the substrate with a coating, usually a resin, areas of which can be selectively removed by the plate maker to provide a printing plate having areas of different degrees of hydrophilicity/phobicity. Inks used to print from the plates are oleophilic (hydrophobic) so are deposited only on the hydrophobic areas of the plates.

The resin that is coated onto the plate has conventionally been a photo-sensitive resin, which on exposure to light becomes more or less easily removable by the development process. In the case of negative plates exposure cures the resin by initiating polymerisation of prepolymer. The unexposed and unpolymerised resin can then be selectively removed by application of, for instance, an acid or alkaline solution or an organic solvent, most commonly an aqueous alkaline solution containing surfactants and solvents. In the case of positive plates exposure to light cleaves bonds to render the coating more soluble in alkali. Thus, exposed resin can be removed by application of a developer, usually an alkaline developer. Conventionally the same processors have been used for developing both positive and negative presensitised plates.

In the development of photo-sensitive plates there is preferably a rinse or wash step following development by the alkaline or other developer. Rinsing is generally carried out by application of water. For some photo-sensitive resins application of water terminates the development process making it impossible to remove unexposed resin. It is therefore essential that all of the uncured areas are removed before the plate passes to the washing step. In order to promote removal, development baths for positive and negative plates have been provided with brushes or other mechanical means for abrading the resin on the plate surface. In the developer bath developer solution is generally applied to the plates by spraying or other means and is conveniently also applied direct to any brushes to maximise removal of the resin. In the wash stage water is generally applied to the plate surfaces by spraying or other means without application of abrasive force. The washing is intended to remove residues of the developer solution rather than of resin.

Although there have been processes which do not apply abrasive force by brushes in the developer step, replacing this by the use of high pressure liquid jets or the use of organic solvents or omitting agitation altogether, these have always been intended to remove resin in that developer stage. Such processes have not been found to provide entirely satisfactory development.

Another type of litho plate comprises an electrostatic sensitive coating of an "organic photo conductor" or OPC resin. To produce a printing plate, the coating is electrostatically charged in discrete areas of the plate. This may be achieved in one of two ways. The coating can be charged over the entire plate surface, and then the charge is selectively cancelled in areas, generally the non-image areas. Generally the charge is cancelled by application of electromagnetic radiation, usually light. Alternatively the coating is pretreated with electromagnetic radiation in discrete areas which prevents electrostatic charge being refined and is then charged. Light or other radiation is directed at the plate by a camera, or using laser beam from a laser printer. In the next step a toner is applied, which can be in liquid or solid particulate form and generally comprises a low-melting resin and a pigment, for instance a carbon pigment. The toner is deposited selectively onto the charged areas of the plate. The plate is then heated to evaporate any solvent and fuse the toner. Application and curing of the toner is sometimes termed developing since it produces a black image on the plate, although those steps are not strictly speaking analagous to the development steps of a conventional presensitised plate production process, ie in which the resin is photo-sensitive.

The plate is then subjected to a decoating operation, in which the OPC resin is removed from the toner-free areas of the plate. The decoating operation has generally been carried out using the same apparatus as has been used for developing photo-sensitive plates. The process has thus consisted of application of developer solution, generally an alkaline solution, to the plate with brushing, optionally followed by a washing stage.

Plates produced by development in the conventional apparatus were not entirely satisfactory and produced low quality plates with inadequate resolution. One solution to the problem that had been proposed was the provision of extra brushes in the developer bath but this can reduce the quality yet more.

In JP-A-61-230149 (1986) a plate processor is described which is useful for various types of plate, including electrostatic sensitive plates. The processor has a high concentration developer in a first step and a lower concentration in a second step. There may be abrasion means in the second and optionally also in the first developer step to remove coating. The excess developer solution is recirculated in each step.

According to the present invention there is provided a process for decoating an electrostatic sensitive resin coated plate that has toner image-wise coated over the resin, in which the plate is decoated in the areas unprotected by toner by contact with a developer solution and then a washing liquid, and which is characterised by comprising
a) a first, soaking step in which an aqueous developer solution is applied to the plate to soften but not remove the coating such that substantially no coating is removed from the plate during the soaking step, and
b) a second, washing step in which an aqueous liquid is applied to the plate to remove the softened coating and is characterised in that the excess developer solution that is collected in step a) is recirculated in the process and in which the water collected from step b) is not recirculated.

Substantially no resin is removed from the plate by the developer solution; the developer merely softens the coating and enables it to be removed by the aqueous wash liquids.

The process according to the invention for producing a litho printing plate product from a plate having a coating of an electrostatic sensitive resin comprises the following steps:
1. electrostatically charging the coating in discrete areas of the plate,
2. applying a toner, which is selectively attracted to the charged areas, to the plate,
3. curing the toner,
4. subjecting the plate to a decoating operation to remove the electrostatic sensitive coating material from the areas not protected by toner, and is characterised in that the decoating operation comprises
   (a) a first, soaking step in which an aqueous developer solution is applied to the plate to soften but not remove the coating such that substantially no coating is removed from the plate during the soaking step, and
   (b) a second, washing step in which water is applied to the plate to remove the softened coating and in that the excess developer solution that is collected in step a) is recirculated in the process and in which the water collected from step b) is not recirculated.

The present invention also provides printing plates produced by the new process.

The new process has been found to produce plates having a far higher quality than the conventional process of brushing in developer solution. The process can be used to make OPC plates having much improved quality than has yet been possible. The process thus benefits from the advantages afforded by the OPC process in general as compared to the use of photo-sensitive plates, including savings made by dispensing with the requirement for photographic film and the associated development stages. We found that development of OPC plates is not terminated by the application of water in the washing step. The new process is highly advantageous since it significantly increases the lifetime of the developer bath since it does not become contaminated and neutralised by resin that has been removed from the plate. Resin is removed into the wash bath which generally does not comprise any large amounts of active chemicals and so is inexpensive and easier to dispose of. Furthermore we have found that the plates produced by the process have improved definition or reduced "sharpening" compared to OPC plates made by the usual processes. We believe this improvement, is due to a reduction in removal of toner and OPC resin thereby left unprotected in the developer bath.

The developer is any conventional OPC or positive developer solution and is generally an aqueous alkaline solution, usually comprising silicate, optionally containing surfactant. Suitable developers comprise for instance alkali metal silicate, usually sodium silicate, for instance sodium metasilicate in concentrations of about 2 to 10% by weight usually 5 to 6% by weight, suitable surfactants, which aid penetration of the coating, comprise cationic surfactants eg. carboxy-methyl fatty acid amido-ethyl amine. The solution is applied in amounts sufficient to wet the entire surface, for instance by flooding with solution or by dipping the plate into a developer bath.

The developer solution is recirculated in the process, by collecting excess solution and recirculating it to the application means.

In the washing step, the resin is generally removed from the plate by abrasion, although sometimes it may be possible to use high pressure liquid jets. In the most convenient embodiment of the process the coating is removed by brushing the plate surface. The washing is usually carried out by water, usually mains water, and is preferably free of additives. The wash water is not recirculated.

In the process it is preferable that soaking is carried out in the developer for at least 10 seconds, preferably at least 15 seconds and more preferably at least 20 or 30 seconds. Usually it is not necessary for the period to be more than 5 minutes and up to 60 seconds is often sufficient. In general it is preferred for the period to be kept to a minimum to prevent attack by the developer of resin in the image areas, for instance under the toner in an OPC plate. Thus the rate of progress of a plate through the process is suitable to ensure that the time between the first application of developer solution, for instance by spraying, flooding or dipping or other means, and before the application of water in the washing step, is at least those minimum periods mentioned.

The process may comprise a further rinsing step after the washing step, if desired, for instance in which the plate is rinsed with pure water. The process may also comprise a subsequent step in which a gum is applied to the plate, to protect the plate during storage or for other purposes including protection of the plate during a subsequent baking stage in the process. Such gum solutions are conventional for application to litho plates and comprise, for instance, dextrin gums in concentrations of 2 to 15% by weight, preferably 6 to 10% by weight. The plates may also be subjected to a subsequent drying stage, for instance in which they are heated and/or air dried. The plates may sometimes be baked, to increase the possible print run, for instance at a temperature of about 220°C.

According to the invention there is also provided apparatus suitable for carrying out the decoating process comprising a plate processor and an electrostatic sensitive plate that has toner image-wise coated oven a resin, in which the plate processor comprises a developer bath, means selected from spray means, flooding means and dipping means for applying developer solution from the developer bath to the plate passing through the apparatus, means for applying wash water to the plate, means for removal of resin from the plate whilst it is in contact with the wash water, means for recirculating the developer solution and which does not include means for recirculating wash water. Usually the apparatus is arranged for passage of the plate substantially horizontally with its coated surface uppermost.

In the new apparatus the means for removal of the resin generally comprises means for applying abrasion to the surface, preferably roller brushes. Suitable brushes may have very soft bristles or may comprise a sleeve of a velour material for instance of the type used as wetting rollers on printing presses. For most applications the brushes are suitable for applying abrasion to one side of the plate only although in some circumstances a double sided plate may be produced in which case brushes can be provided on both sides of the plate. Usually the brushes are driven for instance in the same direction as the plate moves.

The means for application of developer comprises spray means, flooding means or means for dipping the plate into developer solution. The apparatus comprises means for recirculating excess developer to the application means, for instance comprising a bath positioned for collecting excess solution and pump means for pumping liquid from the bath to the application means.

The means for applying wash water may comprise spray means for applying water to the plate surface for instance immediately on entry of the plate to the washing section. Preferably there are means also for applying water to the brushes to optimise removal of resin. Conveniently there are further means for applying water after the abrasion has been applied, to act as a final rinse before the plate is transported out of the washing section.

The apparatus generally comprises dam means for preventing solutions from flowing backwards or forwards in the apparatus to contaminate other areas. The apparatus also comprises means for collecting wash water and removed resin.

The apparatus may be an open bath apparatus which is open to the air or the developer bath at least may be closed. This increases the life of an alkaline developer solution by minimising uptake by the solution of carbon dioxide from the air which would neutralise the alkaline developers.

The apparatus may also comprise means for applying a solution of preserving or other gum to the plate after the washing step. The apparatus may also comprise means for carrying out other intermediate steps, for instance intermediate rinsing steps. The means for application of gum solution and/or immediate rinsing means may comprise similar application means as for the developer solution and washing solution, e.g. spray means. The apparatus may also comprise a drying means for a final drying step. This may comprise means for directing a flow of warm air at the plate surface.

Although the apparatus may be manually operated, it is preferably provided with automated transport means, for instance comprising motorised transport rollers as well as sensors. These transport means allow the apparatus to be set for optimum operating conditions, for instance to maintain the plate for the optimum periods in the various stages of the apparatus and for application of optimal amounts of developer, water and gum, as well as for driving the various rollers and brushes when and how necessary.

The apparatus may be part of an automated plate line that may comprise also modules for carrying out the other stages of the plate making process, including, for an OPC process, charging means, means for discharging selected areas usually comprising an optical camera or a laser and means for application and curing of toner. For a process for forming plates from a positive photosensitive plate the line includes means for exposing image areas to light. Also the line may comprise means for carrying out subsequent stages, such as baking which can further cure the resin and increase the life of the plate, as well as means for applying and/or removing various protective coatings, for instance fusing gums used to protect the plate during baking.

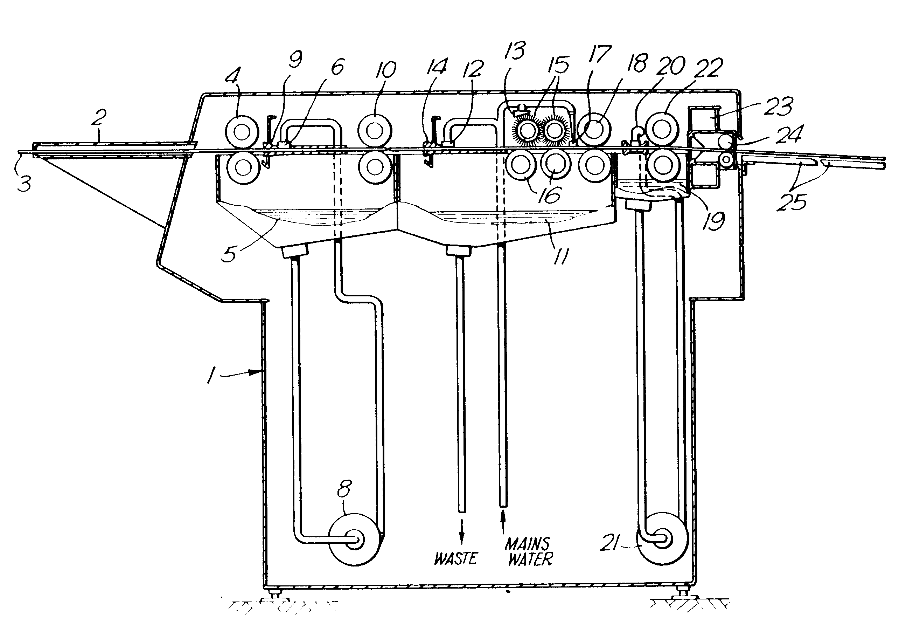

The accompanying drawing shows a schematic diagram of a preferred embodiment of the apparatus.

A processor 1 comprises a feed table 2 on which can be supported a plate 3 prepared for processing with its coated side uppermost. The plate is fed via rubber coated transport rollers 4 to a position above a developer bath 5. Whilst it is above that bath developer solution is applied to wet the upper coated surface of the plate via a spray bar schematically represented as 6. Excess solution is collected in the bath and is recirculated by recirculating pump 8 to the spray bar. Developer solution is prevented from flowing backwards by rubber dams 9 and to some extent by the rollers 4 acting as squeegees.

The plate is then transported by transport rollers 10 to a position above a washing bath 11. Rollers 10 prevent flow forwards of developer solution into the washing bath 11 by acting as squeegees. Whilst in position above the wash bath water is applied to the upper, coated surface of the plate by spray bar schematically illustrated as 12. Excess water is collected in the bath 11 and is prevented from flowing backwards into the developer solution by rubber dams 14. Rubber dams 9 or 14 could be omitted by providing the plate path at a slope to the horizontal so that gravity would prevent flow of liquid either backwards or forwards. Two brushes 15 on the upper side of the plate are rotated whilst in contact with the upper surface of the plate which bears against pressure bars 16 underneath the plate, thereby removing resin from the parts of the plate which are soluble in developer. The brushes are preferably rotated so that they are moving in the same direction as, but faster than, the plate. They may be capable of reversing for a part of the process, for instance as the back end of the plate passes them. To improve removal of resin further water is applied to the plates via the first brush 15 from spray bar 13. Additionally further water is applied as a rinse from spray bar 17 located further upstream from the brushes. Excess wash water is collected in the bath 11 and is sent to waste. Spray bars 12, 13 and 17 are supplied with fresh water from the mains.

From the wash section the plate is transported by transport rollers 18 to the gumming section. Rollers 18 prevent the washing solution from flowing forward in the processor and contaminating the gumming section. In the gumming section a gum solution is contained in a bath 19 and is applied via a spray bar 20 which is supplied with gumming solution from the tank 19 by recirculating pump 21.

From the gumming section the plate is transported by transport rollers 22 to a drier assembly generally illustrated as 23 which consists of a heater for air and a fan to blow warm air onto the plate surface. An ejector assembly 24 transports the plate onto a delivery table 25 from where the plate can be removed for storage or for printing.

The following example illustrates the invention:

An aluminium plate that had been provided with an OPC coating comprising an oxadiazole derivative of vinyl acetate copolymer and an anthraquinone pigment at a coating weight of about 5g/m² was electrostatically charged over its entire surface. Areas of the coating were selectively discharged by application of light from an optical camera. The plate was subsequently contacted with a liquid toner which was selectively attracted to the parts of the coating remaining electrostatically charged.

The plate was then heated to a temperature of 180°C to drive off solvent and to fuse the toner, and was then cooled to ambient temperature. The plate was then processed through the apparatus described above.

In the developer bath was a developer solution comprising 5 to 6% sodium metasilicate and 0.2% carboxymethyl fatty acid amidoethylamine. This was applied to wet the plate at room temperature. The rate of progress of the plate through the apparatus was such that the time from first application of the developer solution to transport out of the developer area by the transport rollers was 40-45 seconds. The plate then passed into the washing section, where pure mains water at ambient temperature was applied to the plate via spray bars and from the brushes. The plates were brushed using 2 rollers with velour sleeves rotating in the same direction as the movement of the plate. The plates were then passed by transport rollers into the gumming section where an aqueous solution of about 8% of dextrin gum was applied by spray bar. The plate was then dried by warm air and ejected.

This plate was compared with a comparative plate produced by the same process but which was decoated by the conventional method, that is by application of developer whilst brushing with the same type of brushes as used in the invention but in the developer bath, followed by rinsing with pure water applied from spray bars only, followed by the same gumming and drying steps. The plate produced by the process of the invention and the comparative plate were subjected to tests to compare the quality of printing by measuring the screen range for each plate.

The screen range is the range of halftone dot sizes that can be reproduced on the plate at a given screen ruling (dots per inch = 25,4 mm) expressed in percentage aggregate area of the dots per unit area.

A conventional processor gave a screen range of 20% to 80% at 100 lines per inch screen ruling on the plate. Under the same conditions the new processor gave a screen range of 10% to 80%, showing less undercutting of the highlight dots.

The capacity of developer in the conventional processor is 7 square metres per litre. The developer is exhausted by the build up of products of the development reaction and coating solids. In the new processor capacity is increased to 12 square metres per litre.

## Claims

1. A process for decoating an electrostatic sensitive resin coated plate that has toner image-wise coated over the resin, in which the plate is decoated in the areas unprotected by toner by contact with a developer solution and then a washing liquid, and which is characterised by comprising
a) a first, soaking step in which an aqueous developer solution is applied to the plate to soften but not remove the coating such that substantially no coating is removed from the plate during the soaking step, and
b) a second, washing step in which water is applied to the plate to remove the softened coating and in which the excess developer solution that is collected in step a) is recirculated in the process and in which the water collected from step b) is not recirculated.

2. A process for producing a litho printing plate product from a plate having a coating of an electrostatic sensitive material comprising the following steps:
(1) electrostatically charging the coating in discrete areas of the plate,
(2) applying a toner, which is selectively attracted to the charged areas, to the plate,
(3) curing the toner,
(4) subjecting the plate to a decoating operation to remove the electrostatic sensitive coating material
from the areas not protected by toner, and is characterised in that the decoating operation comprises
(a) a first, soaking step in which an aqueous developer solution is applied to the plate to soften but not remove the coating such that substantially no coating is removed from the plate during the soaking step, and
(b) a second, washing step in which water is applied to the plate to remove the softened coating and in which the excess developer solution that is collected in step a) is recirculated in the process and in which the water collected from step b) is not recirculated.

3. A process according to claim 1 or 2 in which the developer solution is an alkaline solution, preferably comprising alkali metal silicate, more preferably sodium metasilicate.

4. A process according to any preceding claim in which the softened resin is removed in step b) by abrasion, preferably by brushing the plate coating.

5. A process according to any preceding claim in which the soaking step is carried out for a period of at least 20 seconds preferably at least 30 seconds.

6. A process according to any preceding claim in which the developer solution is applied to the plate by spraying alone.

7. Apparatus comprising a plate processor and an electrostatic sensitive plate (3) that has toner image-wise coated over a resin, in which the plate processor comprises a developer bath (5), means (6) selected from spray means, flooding means and dipping means for applying developer solution from the developer bath (5) to the plate passing through the apparatus, means (12) for applying wash water to the plate, means (15,16) for removal of resin from the plate whilst it is in contact with the wash water and means (8) for recirculating the developer solution and which does not include means for recirculating wash water.

8. Apparatus according to claim 8 in which the means for removal of resin comprises abrasion means, usually brushes, provided above the wash bath.

9. A plate line for producing litho plates from electrostatic sensitive plates comprising means for electrostatically charging discrete areas of a plate coated with an organic photo-conducting polymer, means for applying a toner that is selectively attached to the charged areas of the plate, means for curing the toner and means for decoating the plate characterised in that the decoating means comprises a processor as defined in claims 7 ou 8.

## Patentansprüche

1. Verfahren zum Entfernen einer Beschichtung eines Elektrostatik-empfindlichen, auf eine Platte aufgetragenenen Harzes, die einen abbildungsgemäß über dem Harz aufgetragenen Toner aufweist, bei dem die Beschichtung an der Platte in vom Toner nicht geschützten Flächen entfernt wird durch Kontakt mit einer Entwicklerlösung und dann einer Waschflüssigkeit, gekennzeichnet durch
a) einen ersten, Wässerungsschritt, bei dem eine wässrige Entwicklerlösung auf die Platte aufgetragen wird, um die Beschichtung weich zu machen, aber nicht zu entfernen derart, daß während des Wässerungsschritts im wesentlichen keine Beschichtung von der Platte entfernt wird, und
b) einen zweiten, Waschschritt, bei dem Wasser zum Entfernen der weichgemachten Beschichtung auf die Platte aufgebracht wird und bei dem die überschüssige Entwicklerlösung, die im Schritt a) gesammelt wird, im Arbeitsablauf rückgeführt wird, und bei dem das aus Schritt b) gesammelte Wasser nicht rückgeführt wird.

2. Verfahren zur Herstellung eines lithographischen Druckplattenprodukts aus einer Platte, die eine Beschichtung eines Elektrostatik-empfindlichen Materials aufweist, mit folgenden Schritten:
(1) Elektrostatisches Laden der Beschichtung an diskreten Flächen der Platte,
(2) Aufbringen eines Toners auf die Platte, der selektiv zu den geladenen flächen hingezogen wird,
(3) Aushärten des Toners,
(4) Unterziehen der Platte eines Entfernungsvorgangs, um das Elektrostatik-empfindliche Beschichtungsmaterial zu entfernen
von den vom Toner nicht geschützten Flächen, dadurch gekennzeichnet, daß der Entfernungsvorgang
(a) einen ersten, Wässerungsschritt, bei dem eine wässrige Entwicklerlösung auf die Platte aufgetragen wird, um die Beschichtung weich zu machen, aber nicht zu entfernen derart, daß im wesentlichen während des Wässerungsschritts keine Beschichtung von der Platte entfernt wird, und
(b) einen zweiten, Waschschritt aufweist, bei dem Wasser zum Entfernen der weichgemachten Beschichtung auf die Platte aufgebracht wird, und bei dem die überschüssige Entwicklerlösung, die im Schritt a) gesammelt wird, im Arbeitsablauf rückgeführt wird und bei dem das aus Schritt b) gesammelte Wasser nicht rückgeführt wird.

3. Verfahren nach Anspruch 1 oder 2 dadurch gekennzeichnet, daß die Entwicklerlösung eine alkalische Lösung ist, vorzugsweise mit einem Alkalimetallsilikat, insbesondere Natriummetasilikat.

4. Verfahren nach einem der vorstehenden Ansprüche, dadurch gekennzeichnet, daß das weichgemachte Harz beim Schritt b) durch ein Abreiben entfernt wird, vorzugsweise durch Bürsten der Plattenbeschichtung.

5. Verfahren nach einem der vorstehenden Ansprüche, dadurch gekennzeichnet, daß der Wässerungsschritt für eine Zeitdauer von wenigstens 20 Sekunden, vorzugsweise wenigstens 30 Sekunden durchgeführt wird.

6. Verfahren nach einem der vorstehenden Ansprüche, dadurch gekennzeichnet, daß die Entwicklerlösung durch Sprühen alleine auf die Platte aufgetragen wird.

7. Vorrichtung mit einer Plattenbearbeitungseinrichtung und einer Elektrostatikempfindlichen Platte (3), die einen Toner abbildungsgemäß über einem Harz aufgetragen aufweist, dadurch gekennzeichnet, daß die Plattenbearbeitungseinrichtung ein Entwicklerbad (5), eine aus Sprüheinrichtungen ausgewählte Einrichtung (6), eine Flutungseinrichtung und eine Eintaucheinrichtung zum Aufbringen von Entwicklerlösung aus dem Entwicklerbad (5) auf die die Vorrichtung durchlaufende Platte, eine Einrichtung (12) zum Aufbringen von Waschwasser auf die Platte, eine Einrichtung (15, 16) zum Entfernen von Harz von der Platte, während sie mit dem Waschwasser in Berührung steht und eine Einrichtung (8) zum Rückführen der Entwicklerlösung aufweist, die keine Einrichtung zum Rückführen des Waschwassers beinhaltet.

8. Vorrichtung nach Anspruch 7, dadurch gekennzeichnet, daß die Einrichtung zum Entfernen von Harz eine Abriebeinrichtung aufweist, überlicherweise Bürsten, die oberhalb des Waschbades vorgesehen sind.

9. Plattenstraße zur Herstellung von lithographischen Platten aus Elektrostatik-empfindlichen Platten mit einer Einrichtung zum elektrostatischen Aufladen diskreter Flächen einer mit einem organischen fotoleitenden Polymer beschichteten Platte, einer Einrichtung zum Aufbringen eines Toners, der selektiv an den aufgeladenen Bereichen der Platte angeordnet ist, einer Einrichtung zum Aushärten des Toners und einer Einrichtung zum Entfernen der Beschichtung an der Platte, dadurch gekennzeichnet, daß die Entfernungseinrichtung eine Bearbeitungseinrichtung nach Anspruch 7 oder 8 aufweist.

## Revendications

1. Procédé permettant de dénuder une plaque revêtue de résine sensible à une action électrostatique, une image de toner étant appliquée en revêtement par-dessus cette résine, procédé selon lequel, dans les zones non protégées par le toner, la plaque est dénudée par mise en contact avec une solution de révélateur, puis avec un liquide de lavage, caractérisé en ce qu'il comprend :
a) une première opération, de mouillage, dans laquelle une solution aqueuse de révélateur est appliquée à la plaque de façon à ramollir le revêtement, mais non pas à l'éliminer, de manière telle qu'il ne soit pratiquement pas retiré de revêtement de la plaque pendant cette opération de mouillage, et
b) une seconde opération, de lavage, dans laquelle de l'eau est appliquée à la plaque de façon à éliminer le revêtement ramolli, l'excès de solution de révélateur qui est recueilli à l'opération a) est remis en circulation dans le procédé et l'eau recueillie à l'opération b) n'est pas remise en circulation.

2. Procédé permettant de réaliser un produit, formé d'une plaque lithographique, à partir d'une plaque comportant un revêtement d'une matière sensible à une action électrostatique, comprenant les étapes suivantes :
(1) charger électrostatiquement le revêtement dans des zones discontinues de la plaque,
(2) appliquer à la plaque un toner qui est attiré de manière sélective sur les zones chargées,
(3) faire durcir le toner,
(4) soumettre la plaque à une opération de dénudage de façon à éliminer des zones non protégées par le toner la matière de revêtement sensible à une action électrostatique,
caractérisé en ce que l'étape de dénudage comprend :
a) une première opération, de mouillage, dans laquelle une solution aqueuse de révélateur est appliquée à la plaque de façon à ramollir le revêtement, mais non pas à l'éliminer, de manière telle qu'il ne soit pratiquement pas retiré de revêtement de la plaque pendant cette opération de mouillage, et
b) une seconde opération, de lavage, dans laquelle de l'eau est appliquée à la plaque de façon à éliminer le revêtement ramolli, l'excès de solution de révélateur qui est recueilli à l'opération a) est remis en circulation dans le procédé et l'eau recueillie à l'opération b) n'est pas remise en circulation.

3. Procédé suivant l'une des revendications 1 et 2, selon lequel la solution de révélateur est une solution alcaline, comprenant de préférence un silicate de métal alcalin, mieux le métasilicate de sodium.

4. Procédé suivant l'une quelconque des revendications précédentes, selon lequel la résine ramollie est éliminée à l'opération b) par abrasion, de préférence par brossage du revêtement de la plaque.

5. Procédé suivant l'une quelconque des revendications précédentes, selon lequel l'opération de mouillage est exécutée pendant une période d'au moins 20 secondes, de préférence d'au moins 30 secondes.

6. Procédé suivant l'une quelconque des revendications précédentes, selon lequel la solution de révélateur est appliquée à la plaque uniquement par pulvérisation.

7. Installation comprenant un dispositif de traitement de plaque et une plaque sensible à une action électrostatique (3) qui comporte une image de toner appliquée en revêtement par-dessus une résine, installation dans laquelle le dispositif de traitement de plaque comprend un bain de révélateur (5), un moyen (6) choisi parmi un moyen de pulvérisation, un moyen d'immersion et un moyen de trempage et permettant, à partir du bain de révélateur (5), d'appliquer une solution de révélateur à la plaque traversant l'installation, un moyen (12) permettant d'appliquer de l'eau de lavage à la plaque, des moyens (15, 16) permettant d'éliminer de la plaque la résine pendant que cette plaque est au contact de l'eau de lavage, et un moyen (8) permettant de remettre en circulation la solution de révélateur et qui ne comporte pas de moyen permettant de remettre en circulation l'eau de lavage.

8. Installation suivant la revendication 7, dans laquelle les moyens d'élimination de la résine comprennent des moyens d'abrasion, couramment des brosses, prévus au-dessus du bain de lavage.

9. Ligne pour plaques, permettant de produire des plaques lithographiques à partir de plaques sensibles à une action électrostatique, cette ligne comprenant un moyen permettant de charger électrostatiquement des zones discontinues d'une plaque revêtue d'un polymère photoconducteur organique, un moyen permettant d'appliquer un toner qui est attaché sélectivement aux zones chargées de la plaque, un moyen permettant de faire durcir le toner et des moyens permettant de dénuder la plaque, cette ligne étant caractérisée en ce que les moyens de dénudage comprennent un dispositif de traitement suivant l'une des revendications 7 et 8.
